# EUROPEAN PATENT SPECIFICATION

(11) **EP 0 273 031 B1**
(45) Date of publication and mention of the grant of the patent: **13.10.1993**
(21) Application number: 86903961.0
(22) Date of filing: 03.06.1986
(51) Int. Cl.: H04B 1/16

(54) **CHARACTERIZED FAST TUNING CONTROL FOR A TELEVISION SYSTEM**
CHARAKTERISTISCHE SCHNELLE ABSTIMMSTEUERUNG FÜR EIN FERNSEHVERFAHREN
COMMANDE DE SYNTONISATION RAPIDE CARACTERISEE POUR UN SYSTEME DE TELEVISION

(43) Date of publication of application: 06.07.1988
(73) Proprietor: INFORMATION RESOURCES, INC., Chicago, IL 60606 (US)
(72) Inventor: WRIGHT, W., Andrew, Jr., Bethlehem, PA 18017 (US)
(74) Representative: Cross, Rupert Edward Blount
(86) International application number: US8601216
(87) International publication number: WO8707794

(56) References cited:
- EP-A- 0 077 589
- US-A- 4 079 320
- US-A- 4 085 371
- US-A- 4 220 922
- US-A- 4 247 952
- US-A- 4 272 729
- US-A- 4 287 601
- US-A- 4 298 988
- US-A- 4 476 584
- US-A- 4 525 866
- US-A- 4 568 888
- ELECTRONICS INTERNATIONAL, vol. 55, no. 14, 14th July 1982, pages 156-158, New York, US; G. TWIBELL: "High-performance hf receiver cashes in on diverse digital functions"
- PATENT ABSTRACTS OF JAPAN, vol. 9, no. 178 (E-330)[1901], 23rd July 1985; & JP-A-60 48 618 (NIPPON DENSHIN DENWA KOSHA) 16-03-1985
- NATIONAL TELECOMMUNICATIONS CONFERENCE, Houston, Texas, 30th November - 4th December 1982, conference Record, vol. 1, pages 22.3.1 - 223.5, IEEE, New York, US; R.R. RHODES et al.: "Frequency agile phase-locked loop synthesizer for a communications satellite"
- PATENT ABSTRACTS OF JAPAN, vol. 7, no. 4 (E-151)[1149], 8th January 1983; & JP-A-57 162 527 (FUJITSU K.K.) 06-10-1982

## Description

The present invention relates to television systems and more particularly to fast tuning subsystems for switching channels in a television system. Still more particularly, it relates to such subsystems in which a selected substitute television signal in a substitute channel can be substituted indistinguishably for one or more normal televison signals in respective normal channels, as for market research purposes.

Marketing research techniques have been developed in which a substitute television signal in a substitute channel, containing a commercial the effectiveness of which is to be assessed, is substituted for a normal television signal in a normal channel in homes of selected test viewers so that the effectiveness of the commercial can be evaluated. This allows the promoter of a service or product to assess the reaction of a small, demographically controlled panel of test viewers before the wide airing of a commercial which may prove ineffective.

One example of such a television signal substitution system is disclosed in United States Patent US-A-4,404,589. As there disclosed, substitute television program signals are transmitted in at least one substitute channel along with signal substitution control signals. A control box or terminal at each test viewer receiver responds to the signal substitution control signals by selectively switching to a substitute television program from a normal program. The signal substitution control signals include a number of different terminal command signals and a number of different event command signals. Each of the terminal command signals includes a respective test viewer address signal for identiying a respective test viewer receiver and a number of event identification signals identifying respective signal substitution events in which this terminal is to participate. Each of the event command signals includes a respective event address signal corresponding to a respective event, an appropriate substitution control command, a substitute channel identification signal, and one or more normal channel identification signals for identiying the normal channels from which the receiver is to be switched. The current event command signals corresponding to each allowable event address are stored in the terminal for later correlation with the terminal's participation event list and with the viewer's selected channel signal. When the viewer selected channel corresponds to a normal channel identification signal associated with a current event command whose event address signal corresponds to an event in which the respective terminal is to participate, the substitute channel is substituted for the channel selected by the viewer for a period determined by the event command signals. Subsequent responses to the events, such as purchases, of the respective viewers are then individually tabulated and analyzed against the responses of viewers receiving the normal signals.

When a viewer changes channels on a modern television receiver, the channel change is carried out in, for example, about a quarter of a second. The change is accompanied by momentary disruption of the picture and a sound pop or a period of sound muting. When a market research company causes a channel substitution, it is desirable that the substitution be carried out so quickly and unobtrusively as to be imperceptible to the normal test viewer. If the substitution were distinguishable, it could, at least subconsciously, influence the response of the test viewer to the commercial. That is, were the viewer to know or suspect he was receiving a test commercial, he might react in a manner in which he believes he is expected to react, rather than acting normally, skewing the test results from his normal response. Therefore, it is desirable that the tuning be accomplished extremely rapidly so as to be indistinguishable. More specifically, the transition time between channels should be kept well within about 60 microseconds to prevent an audible pop due to loss of the television signal intercarrier frequency modulated with the sound subcarrier. The normal and substitute channel tuning should be very accurately matched to ensure no shift in picture quality, particularly that of the chroma signal. The transition should be timed to occur during the vertical blanking interval between picture fields so that the change is not seen by the viewer.

Switching channels may require a large frequency change in the tuner. For example, if the normal channel is a low VHF channel (wherein Channel 2 has a video carrier frequency of 55.25 MHz) and the substitute channel is a high UHF channel (wherein Channel 70 has a video carrier frequency of 807.25 MHz), the tuner might have to slew through more than 700 MHz. The vertical blanking interval of standard NTSC video, during which the substitution is to be effected, takes 1.3 milliseconds. The factor that is most critical in making the substitution indistinguishable is the sound. The audio stage of the television receiver is not tuned to the sound carrier, but is tuned to the 4.5 MHz intercarrier frequency generated between the video carrier and the sound carrier in each VHF and UHF channel. When the tuner of the receiver tunes between channels, the intercarrier frequency disappears because both the video and sound carriers are no longer simultaneously present in the IF pass band. When the audio stage of the television receiver has no signal applied, its internal limiter amplifier will amplify noise up to the full amplitude level. This causes the pop heard during viewer controlled channel changing. This presents no problem when the viewer changes channels, for it is to be expected. However, if an audible pop were produced during signal substitution, it would alert the viewer to the fact of substitution.

In order to avoid the effect of noise during signal substitution, the channel change must be sufficiently fast that the human ear cannot distinguish it. The total energy of a noise burst is the integral of power over time, but the human ear is essentially logarithmic in perception and can hear extremely low energy noise pulses. To make the noise attendant a channel change unobtrusive, the change should be accomplished in less than about 60 microseconds. Not only is relatively fast tuning required, but also the tuning must be relatively accurate to recover the 4.5 MHz intercarrier beat. Due to the close proximity of the sound carrier of an adjacent channel to the video carrier of a substitute channel, a maximum error of about ± 500 KHz is required for both the video and sound subcarriers of the substitute channel to be within the pass band.

Previous signal substitution systems have employed a cable television distribution system with a control box for channel switching located at each test viewer's home. These systems have employed a fast electronic tuner having a voltage controlled oscillator whose output frequency determined the channel to which the tuner was tuned. A voltage divider network established predicted tuning voltages necessary to cause the local oscillator to translate each individual channel's frequency to that of at least one channel of the television receiver. The tuner was made to select a particular channel very quickly by jamming the appropriate control voltage into the local oscillator, causing it to slew rapidly to the new frequency. This is known as jam tuning. Thus, by directing an electronic switch in the local oscillator control circuit to change from a normal channel voltage to the substitute channel voltage, a rapid substitution could be made. This prior art tuner controller system was predictive in nature in that the channel tuning control voltages corresponding to the desired input channels were determined by testing prior to or during installation of the control box at the home of the test viewer. A problem encountered was that with time the correct tuning voltages tended to drift.

Drifting resulted in frequency errors which caused loss of picture definition, and color hue or saturation changes. The automatic fine tuning circuitry in the television set of the test viewer might correct the error, but it would correct the error in a visible manner due to its slow operating speed. With time, the drifting became so extreme as to require that the control boxes be removed from test viewer homes for recalibration.

U.S. Patent US-A-4,220,922 discloses a fast tuning subsystem for use in switching from a current channel to a selected channel of a television system, said tuning subsystem comprising a tuner for selecting a channel to be received, said tuner including a voltage controlled oscillator having a control input for determining, in response to voltage applied to said control input, the channel frequency said tuner selectively receives, and predictive means for supplying a selected predicted voltage signal to said control input of said oscillator, said predictive means including an associated memory means in which is stored signals corresponding to respective voltage signals predicted for applying to said oscillator to tune said tuner to receive the channel frequencies of the respective channels, and further including means interconnected between said memory means and said control input of said oscillator for applying one of said respective predicted voltage signals as said selected predicted voltage signal to said control input of said oscillator, said oscillator being responsive to said selected predicted voltage signal to slew the channel frequency at a rapid slew rate to the frequency corresponding to said selected predicted voltage signal; error detecting means, including a reference, for generating a tuning error signal indicative of the tuning error of the tuner off the frequency for the selected channel; feedback means for combining said tuning error signal with said selected predicted voltage signal to provide a control signal at said control input for adjusting said channel frequency to reduce said tuning error.

U.S. Patent US-A-4,272,729 discloses a phase locked loop frequency synthezier which utilizes a binary chop method to coarse tune the oscillator. This is a very slow method of tuning, resulting in long delays before the oscillator is correctly tuned.

According to one aspect of the invention a fast tuning subsystem for use in switching from a current channel to a selected channel of a television system, said tuning subsystem comprising a tuner for selecting a channel to be received, said tuner including a voltage controlled oscillator having a control input for determining, in response to voltage applied to said control input, the channel frequency said tuner selectively receives, and predictive means for supplying a selected predicted voltage signal to said control input of said oscillator, said predictive means including an associated memory means in which is stored signals corresponding to respective voltage signals predicted for applying to said oscillator to tune said tuner to receive the channel frequencies of the respective channels, and further including means interconnected between said memory means and said control input of said oscillator for applying one of said respective predicted voltage signals as said selected predicted voltage signal to said control input of said oscillator, said oscillator being responsive to said selected predicted voltage signal to slew the channel frequency at a rapid slew rate to the frequency corresponding to said selected predicted voltage signal; error detecting means, including a reference, for generating a tuning error signal indicative of the tuning error of the tuner off the frequency for the selected channel; feedback means for combining said tuning error signal with said selected predicted voltage signal to provide a control signal at said control input for adjusting said channel frequency to reduce said tuning error, characterized by means for substantially decoupling the operation of said predictive means from the operation of said feedback means by providing a feedback means response time which is long relative to the response time of the predictive means by providing a feedback means response time which is long relative to the response time of the predictive means to prevent transients in the slew mode of said predictive means from substantially perturbing the feedback mode of said feedback means.

It is an embodiment of the invention that the channel frequency be slewed sufficiently fast that the total spurious intercarrier sound energy detected during the slew mode be sufficiently small as to be inaudible to a viewer, and where transients occasioned by operation of the predictive means do not perturb the operation of the feedback circuit so as to cause transient visible degradation of picture as observed by a viewer.

Preferably, the response time of the feedback circuit is at least four orders of magnitude slower than the response time of the predictive means. In another aspect the error detector means includes means for limiting the error signal in magnitude during the interchannel slewing, preferably a phase-error detector limiting the error signal to ± π radians during interchannel slewing.

According to another embodiment, the error detector compares the frequency of the voltage controlled oscillator with the reference to generate the tuning error signal. According to another aspect, such an error detector comprises a reference oscillator for generating a reference signal at a frequency that is 1/N times the frequency of the voltage controlled oscillator at the frequency at which the tuner selectively receives respective channels, where N is a different respective integer for each channel. The error detector further includes divide by N means for dividing the output frequency of the voltage controlled oscillator by N and means for comparing the divided by N signal with the reference signal to produce the tuning error signal. Preferably, the means for decoupling includes a loop filter in circuit with the feedback means.

Another important aspect is the characterizing of the predictive control signal. This must be done accurately and rapidly in the course of manufacture or the cost of characterization of a large number of channels could well become excessive.

The invention also provides a method for establishing in memory a table of predicted control voltages for a slew control for a fast tuning subsystem for use in switching from a current channel to a selected channel of a television system, the tuning subsystem comprising a tuner for selecting a channel to be received, said tuner including a voltage controlled oscillator having a control input for determining, in response to a control voltage applied to said control input, the channel frequency said tuner selectively receives, and a slew control for supplying a selected predicted control voltage signal to said control input of said oscillator, said slew control including an associated memory means for storing signals corresponding to respective control voltage signals predicted for applying to said oscillator to tune said tuner to receive the channel frequencies of the respective channels, and further including means interconnected between said memory means and said control input of said oscillator for applying one of said respective predicted control voltage signals as said selected predicted control voltage signal to said control input of said oscillator, said oscillator being responsive to said selected predicted control voltage signal to slew the channel frequency at a rapid slew rate to the frequency corresponding to said selected predicted control voltage signal, error detecting means, including a reference, for generating a tuning error signal indicative of the tuning error of the tuner off the frequency for the selected channel, and feedback means for combining said tuning error signal with said selected predicted control voltage signal to provide a control signal at said control input for adjusting said channel frequency to reduce said tuning error, characterized by a calibration mode automatically performed to establish a table of the predicted control voltage signals, said calibration mode comprising, for each of a plurality of channels, applying to said control input a respective preliminary control voltage signal corresponding to a previously predicted control voltage signal for that channel, utilizing the resulting tuning error signal from said error detecting means to determine the control voltage signal at said control input as reduces the tuning error signal to less than a predetermined magnitude, and storing in said memory means a signal corresponding to said determined control voltage as a signal corresponding to a respective predicted control voltage signal.

In another embodiment the error detector and the feedback means comprise a phase-locked loop generating a tuning error signal indicative of phase error, the derivative of the tuning error signal is utilized to determine successive incremental updates to the preliminary control voltage signal so as to reduce the tuning error signal to less than a predetermined magnitude, and a signal corresponding to the then characterized preliminary control voltage signal is stored in memory as corresponding to the determined control voltage signal.

In another embodiment the determination of the characterized control voltage signal is made for each channel by applying a respective preliminary control voltage signal to the control input, utilizing the resulting tuning error signal to modify the preliminary control voltage signal by a predetermined amount to produce a modified preliminary control voltage signal, applying the modified preliminary control voltage signal to the control input, and repeating the steps until the resulting tuning error signal is less than the predetermined magnitude.

In another embodiment each predetermined amount is in accordance with a binary search process wherein successive predetermined amounts decrease by half. In another embodiment each predetermined amount is substantially the same in accordance with a linear search process. In still another embodiment each predetermined amount is in accordance with a binary search process for a number of steps wherein successive predetermined amounts decrease by half and is thereafter in accordance with a linear search process wherein each said predetermined amount is substantially the same.

A specific embodiment of the invention will now be described by way of example with reference to the accompanying drawings, in which:
FIG. 1 is a diagram, partly schematic and partly block in nature, illustrating a prior art fast tuning subsystem having predictive tuning voltage control;
FIG. 2 is a block diagram illustrating a fast tuning subsystem according to the present invention having not only predictive tuning voltage control but also a slowly operating phase-locked loop for improving the accuracy of the tuned frequency over time; and
FIG. 3 is a block diagram illustrating the characterizing of the subsystem in the course of its production.

Corresponding reference characters indicate corresponding components throughout the several figures.

A control box is used in a television system for switching between substitute channels and normal channels. The control box is located, for example, at the home of each test viewer and provides a signal input on one of the channels selectable by the television receiver of the test viewer. Each box is under the control of a remote supervisory controller which selects, for example, commercials in a substitute channel for insertion into a selected normal channel for the purpose of testing the effectiveness of each commercial using an appropriately selected panel of viewers. An example of a television system with multi-event signal substitution is shown and discussed in the above-mentioned United States Patent US-A-4,404,589.

As mentioned above, it is desirable that a test viewer not know when a substitute commercial is inserted in place of a commerical in a normal television channel. The judgement of the test viewer could be influenced, if only subconsciously, if the substitution were visually or aurally distinguishable. One way the test viewer could distinguish a substitution is interference with or disruption of the picture or sound. Such interference typically occurs when a television viewer changes normal channels because the electronic tuner of a conventional television set usually takes a fraction of a second to tune to the chosen channel. During this time the 4.5 MHz intercarrier sound signal disappears resulting in a popping noise because the limiter amplifier in the audio FM receiver of the television set amplifies random thermal noise and intervening spurious signals up to the full amplitude level. One aspect of the present invention is the ability to switch between channels so swiftly that the act of signal substitution is indistinguishable by the test viewer.

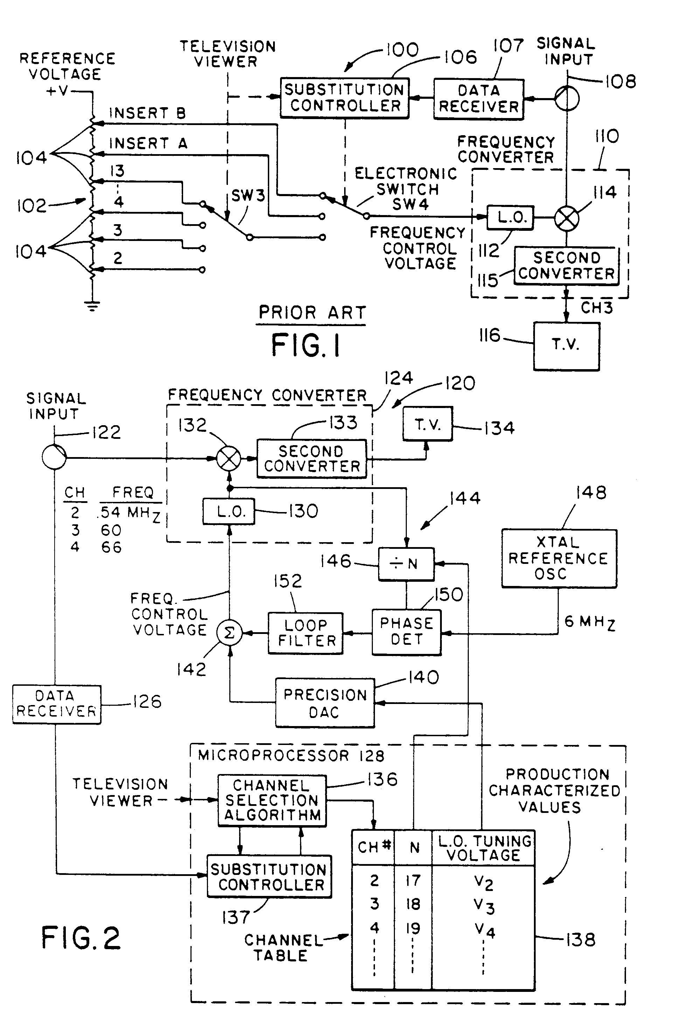

A previously used predictive tuning system is shown in FIG. 1. A control box 100 as previously employed in fast tuning a cable system is there shown. A voltage divider 102 is formed by a number of potentiometers 104 each of which is factory calibrated for the estimated tuning voltage of a respective one of the normal and substitute channels (shown as normal channels 2-13 and substitute channels A and B, respectively). A switch SW3 permits the test viewer to select a normal channel. An electronic switch SW4 is under the control of a signal from a substitute control circuit 106 as provided by way of a data receiver 107 which extracts the control signals from signals received over a cable 108 from a testing facility. The switch SW4 switches among the viewer selected normal channel and the two substitute channels to apply the respective estimated control voltage to a tuner or frequency converter 110. The tuner 110 includes a local oscillator (L.O) 112 and a mixer 114. The local oscillator 112 is a voltage controlled oscillator oscillating at a frequency determined by the control voltage applied to its control input terminal from the switch SW4. The output of the local oscillator 112 is mixed in the mixer 114 with the signal on the cable 108 to produce beat frequencies. A beat frequency for the channel to be detected is at an intermediate frequency which is later converted by a second converter 115 to the frequency to which the viewer's television set 116 is tuned, such as that of a channel not used in the local broadcast area, usually channel 3 or channel 4. Upon operation of the switch SW4 during a vertical blanking interval, the predetermined control voltage for tuning to the desired channel is jammed into the tuner 110. Among the shortcomings of this system are that potentiometers are difficult to adjust precisely during factory calibration, and the system offers no provision for compensation for drift due to the aging of components. With time, the frequency errors of this predictive system became so intolerable that the various channels could not be properly tuned, necessitating the return of the control boxes 100 to the factory for recalibration.

A fast-tuning control subsystem according to the present embodiment is illustrated in FIG. 2. The subsytem includes a control box 120 for receiving signals over a signal transmission medium, which includes a cable 122 in this embodiment. The signals are received by a fast tuner or frequency converter 124 and a data receiver 126. The tuner 124 separates the television signals; whereas the data receiver detects and separates the control signals received from the supervisory testing facility. The fast tuner 124 is under the control of a microprocessor 128 and has two phases or modes of operation, a jam phase and a feedback phase.

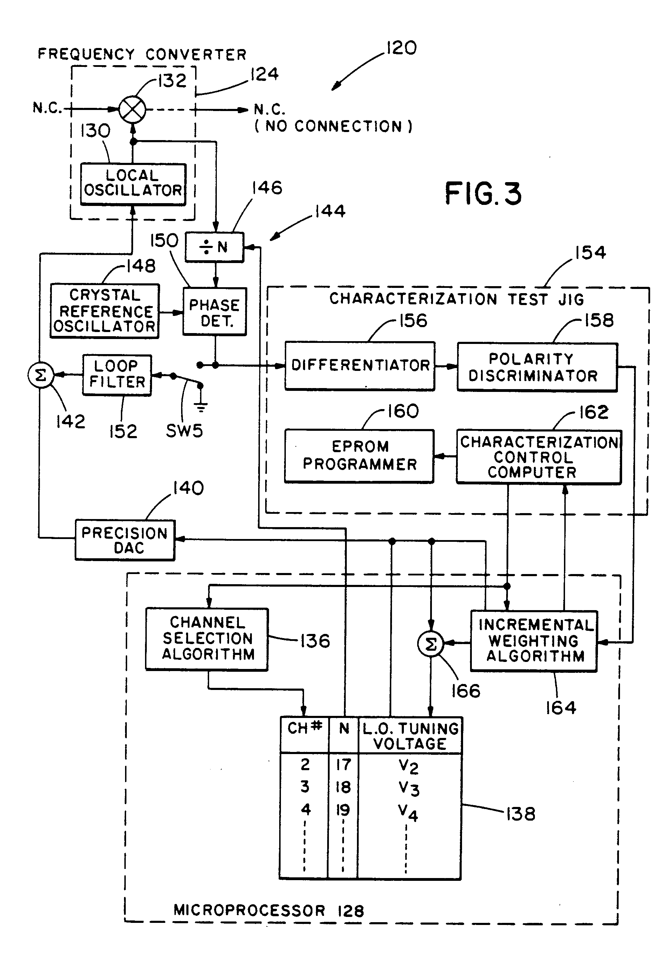

The first phase is the jam phase where a predicted control voltage for the desired channel is applied to the local oscillator (L.O.) 130 of the tuner 124. The local oscillator 130 is a voltage controlled oscillator oscillating at a frequency determined by the control voltage applied to its control input terminal. The output of the local oscillator 130 is mixed in a mixer 132 with the signals received on the cable 122 to produce a beat frequency that for the selected channel corresponds to a fixed intermediate frequency. The signals at the intermediate frequency are then converted by a second converter 133 to a frequency to which the viewer's television set 134 is tuned. Signals corresponding to respective control voltages for tuning the various channels, both substitute and normal, are contained in a channel table 138 in an addressable read only memory associated with the microprocessor 128. The various voltages are predetermined as part of a characterization process performed as a last step of the manufacture of the control box 120, as will be explained further below in connection with FIG. 3. The corresponding signals are stored in the memory table 138 at respective addresses where they are addressed in accordance with an appropriate channel selection algorithm of a channel selector 136 of the microprocessor 128 under the control of a substitution controller 137 of the microprocessor, acting under instructions from the data receiver 126. The microprocessor 128 also receives a signal indicating the channel selection made by the television viewer, as from a selector switch, not shown. Upon channel selection, the microprocessor 128 calls up the corresponding control signal from the memory table 138 and applies the corresponding predetermined, estimated or predicted voltage signal (in digital form) to a precision digital to analog converter (DAC) 140 having 12-14 bit accuracy. The DAC 140 converts the signal to analog form and applies it to the local oscillator 130 by way of a summing circuit 142. The memory table 138 used to store the predicted signal is an erasable programmable read only memory such as an EPROM or an EEPROM. These programmable devices contain a channel table 138 custom programmed to contain signals corresponding to accurate estimates of the frequency control voltage required for each individual frequency converter module 124.

The second phase of tuning is the feedback mode employing an error detection system to determine the difference between the desired frequency output of the local oscillator 130 and actual frequency output. It can usually be safely assumed that the input signal has a reasonably accurate and stable frequency and that significant frequency error results only from the local oscillator 130 in the tuner 124. Thus any frequency error of the tuner output can be accurately assessed by measuring the frequency output of the local oscillator 130. The output of the local oscillator serves as an input to a phase-locked loop (PLL) 144 including a divide by N divider 146 controlled by the microprocessor 128 for selecting an integer N by which the tuner output frequency is divided to reduce it to a frequency that is supposed to match that of a crystal reference oscillator 148. By comparing the phase of the reference oscillator 148 and the phase of the output of the divider 146 using a phase detector 150, an error signal is established for feeding back through a loop filter 152 to the summer 142 for combining with the output of the DAC 140 to bring the local oscillator precisely on the frequency for tuning in the desired channel.

This second or feedback mode of operation is substantially decoupled from the first or jam mode of operation in order that the two modes not interfere with one another. It would be counterproductive for the phase-locked loop to be trying to synchronize the oscillator frequency with the reference while the predicted control voltage is slewing the frequency. More specifically, the act of slewing or jamming provides a random unbalance of the phase-locked loop 144 which the phase-locked loop seeks to reduce. By making the response time of the phase-locked loop 144 sufficiently long relative to the response time of the predictive jamming mode, the two modes may be substantially decoupled. Specifically, the response time must be sufficiently long so that the rate of correction of the random phase unbalance be sufficiently slow so that the resulting transient local oscillator frequency offset be bounded to prevent significant transient visible picture degradation. The response time of the jamming mode is made sufficiently rapid as to slew the tuner to the new channel so fast that the total intercarrier sound noise energy detected during the slew mode is so small as to be inaudible to the viewer. The transients generated as the tuner slews through intervening channel frequencies do not perturb the operation of the feedback means so much as to cause transient visible degradation of the picture observed by a viewer immediately after the jam mode. A response time for the jam mode of less than 60 microseconds has been found appropriate and is readily achieved by appropriate choice of a common local oscillator 130 and a common DAC 140. A response time for the phase-locked loop 144 four orders of magnitude slower than the response time of the predictive slewing circuit has proven effective in providing adequate decoupling. In the specific embodiment actually used, a settling time of the order of three seconds for the phase-locked loop 144 provided effective decoupling. Such settling time for the phase-locked loop 144 is provided by the filter constants of the loop filter 152. The error detector 150 includes means for limiting the error signal during interchannel slewing to further limit the error that must be corrected. This is an inherent property of a phase-locked loop, which limits the error signal to less than ± π .

### Characterization

Characterization is a process performed at the end of the production cycle of each control box 120, or during the recalibration of each control box 120, in which the table of predicted tuning voltages for each normal and substitute channel, called the channel table, is determined and entered in the memory 138. It is these tuning voltages which are jammed into the local oscillator 130 of the tuner 124 to cause the tuner to slew quickly to the chosen channel. These voltages are predetermined with high accuracy because the tuner must arrive promptly within a narrow range of the desired channel in order to prevent a correction in the feedback mode of an initial frequency error sufficient to cause visible picture degradation. Within 100 kHz has proven adequate. In order to realize the desired accuracy, which may approach one part in 10,000, a digital to analog converter having 12 to 14 bit accuracy is provided.

A problem with this factory characterization is that is is a very expensive operation because each individual box 120 must be individually characterized for each of up to about 70 channels. Up to 1000 decisions may be necessary to characterize each box 120. The phase-locked loop 144 settles to equilibrium relatively slowly, taking at least several seconds. This is much too slow to be able to use the equilibrium condition in making these characterization decisions in a low cost manner. As will be explained in greater detail below, these decisions are each more efficiently made in a fraction of a second using a process based upon the derivative of the output of the phase detector 150. The process depends upon the fact that frequency is the instantaneous derivative of phase.

There are numerous considerations in obtaining the desired accuracy. A first consideration is that all critical components of a control box 120 must be used in the characterization of that box. That is, at least the digital to analog converter 140, the frequency converter 124 and the phase-locked loop 144 of the control box 120 are actually used in its characterization. This is because the required accuracy is so high that minute differences which could occur due to the use of different groupings of components cannot be tolerated. A second accuracy consideration is burn in and stabilization. To achieve the required accuracy, the control box 120 is brought up to its final operating temperature and allowed to operate at that temperature until the components reach thermal equilibrium. A third area of concern where extreme accuracy is required relates to the linearity and hysteresis of the components, such as resistors and capacitors.

In order to achieve high speed and at the same time remove the effects of hysteresis, the characterization search for the estimated tuning voltage for each channel is divided into two parts. The first part is a high speed binary search. A crude estimate of the channel tuning voltage is made initially, but typically an eight bit binary search is carried out to get a more accurate estimate of the tuning voltage for the channel. Binary or dichotomizing searches are well known to those of skill in the art and need not be further discussed herein. Such a search involves stepping the test signal in the proper direction by amounts successively decreasing by half to narrow the error. To the extent that components in the circuit exhibit hysteresis or any degree of thermal memory, the result of the binary search is not accurate even when carried to small steps.

The second part of the characterization search involves backing off in the test value some small extent and then proceeding to sweep up through the estimated value (resulting from the binary search) using a linear and constant velocity sweep. Through the use of a linear and constant velocity sweep, all hysteresis effects are aligned in a common direction for all the channels characterized. Any residual hysteresis error is reduced to a constant error term, like the error due to characterizing the box in a temperature environment slightly different than ambient temperature of a test viewer's home, and can readily be removed by the PLL control loop 144.

To implement the characterization process, a characterization test jig 154 is used. The test jig 154 is connected between the output of the phase detector 150 and the microprocessor 128. The test jig includes a differentiator 156 and a polarity discriminator 158 for detecting the sense of tuning error, an EPROM programmer 160 and a characterization control computer 162 for carrying out the test sequence. An incremental weighting algorithm is provided by weighting operator 164 included in the microprocessor 128 itself. A switch SW5 switches the input of the loop filter 152 to ground from its connection to the phase detector 150 to assure that the phase-locked loop 144 does not simultaneously try to correct incremental tuning voltage steps introduced during the characterization process. The phase detector thus senses only the error of the control voltage applied to the summer 142 by the DAC 140.

The characterization control computer 162 puts the test jig 154 through its program sequence. The incremental weighting algorithm responds to the sense of the error as determined by the polarity discriminator 162. It responds by putting out an incremental signal corresponding to an increment or decrement in the control signal to the local oscillator 130. This signal is summed by a summer 166 with a tentative predicted voltage signal from the channel table 138. The initial tentative predicted voltage signals are stored in a test read only memory (ROM) which is plugged into the microprocessor 128 for test purposes to provide initial tentative predicted voltage signals for each channel. As each incremental signal is added to a tentative predicted voltage signal, the sum is stored in a random access memory as a current tentative predicted voltage signal. When the test program is completed for all channels, the EPROM programmer is enabled to put the final predicted voltage signals in an EPROM. The EPROM is then physically inserted in the microprocessor 128 in lieu of the test ROM.

Regarding the necessary speed of the decision making during both the binary search mode and the linear sweep mode of the characterization process for each channel, there may be as many as 1000 decisions necessary to fully characterize each tuner. For the sake of economy, each decision must be made within a small fraction of a second. This speed cannot be obtained by allowing the phase locked loop 144 to settle to accurate values because the time constant of the phase-locked loop itself is many seconds. On the other hand, frequency is the instantaneous derivative of phase. In a search process, all that is required for each decision is a determination of the sense of any error; that may be determined by observing whether a currently observed phase error is increasing or decreasing. This is determined from the slope of the instantaneous derivative of phase by the differentiator 156 which determines the derivative and the polarity discriminator 158 which determines sense. Put more basically, the output of the differentiation is proportional to the rate of change of the phase. If the slope is downward, it means the current value is above the proper value. On the other hand, if the slope is upward, the present value is below the proper value. In this way simple binary decisions can be made rapidly.

In the binary search mode, the incremental weighting algorithm 164 puts out incremental signals wherein each signal after the first is half the value of the preceding incremental signal and of sense determined by the signal from the polarity discriminator 158. The binary search is programmed for eight jumps or tests. After the binary search the linear search continues by fixed increments until the sense changes. That determines the final predicted voltage signal. Thus, the resulting table of tuning voltages is a merger of the invariant field and the accumulated increments to create a channel table, customized to each control box 120. This table is burned into a nonvolatile read only memory, EPROM, and assembled into the memory 138 of each microprocessor assembly 128. As critical components age, the control boxes 120 may be returned to the factory occasionally for recalibration.

Although a preferred embodiment of the invention has been disclosed in some detail, various modifications may be made therein within the scope of the invention. For example, although in the preferred embodiment the system has been designed for operation over cable, the invention may also be used with over-the-air signals.

## Claims

1. A fast tuning subsystem for use in switching from a current channel to a selected channel of a television system, said tuning subsystem comprising a tuner (124) for selecting a channel to be received, said tuner (124) including a voltage controlled oscillator (130) having a control input for determining, in response to voltage applied to said control input, the channel frequency said tuner (124) selectively receives, and predictive means for supplying a selected predicted voltage signal to said control input of said oscillator (130), said predictive means including an associated memory means (138) in which are stored signals corresponding to respective voltage signals predicted for applying to said oscillator (130) to tune said tuner (124) to receive the channel frequencies of the respective channels, and further including means interconnected between said memory means (138) and said control input of said oscillator (130) for applying one of said respective predicted voltage signals as said selected predicted voltage signal to said control input of said oscillator (130), said oscillator (130) being responsive to said selected predicted voltage signal to slew the channel frequency at a rapid slew rate to the frequency corresponding to said selected predicted voltage signal; said tuning subsystem further comprising error detecting means (150), including a reference (148), for generating a tuning error signal indicative of the tuning error of the tuner off the frequency for the selected channel; feedback means (144) for combining said tuning error signal with said selected predicted voltage signal to provide a control signal at said control input for adjusting said channel frequency to reduce said tuning error; said tuning subsystem being characterized by means for substantially decoupling the operation of said predictive means from the operatic of said feedback means by providing a feedback means response time which is long relative to the response time of the predictive means (144)
to prevent transients in the slew mode of said predictive means from substantially perturbing the feedback mode of said feedback means (144).

2. A fast tuning subsystem according to Claim 1 characterized in that said means for substantially decoupling causes the rate at which the channel frequency is slewed by said predictive means to be sufficiently fast that the total intercarrier sound noise energy detected during the slew mode is sufficiently small as to be inaudible to a viewer, whereby transients occasioned by operation of said predictive means do not perturb the operation of said feedback means (144) as to cause transient visible or audible degradation of picture or sound as observed or heard by a viewer.

3. A fast tuning subsystem according to either of Claims 1 or 2 characterized in that said-means for substantially decoupling makes the response time of said feedback means (144) at least four orders of magnitude slower than the response time of said predictive means.

4. A fast tuning subsystem according to any one of Claims 1 to 3 characterized in that said error detecting means (150) includes means for limiting the error signal in magnitude during said interchannel slewing.

5. A fast tuning subsystem according to Claim 4 characterized in that said error detecting means (150) comprises a phase-error detector limiting said error signal to ±π radians during said interchannel slewing.

6. A fast tuning subsystem according to any one or Claims 1 to 5 characterized in that said memory means (138) comprises an addressable memory storing at respective addresses therein a plurality of digital data signals corresponding to predicted voltage signals for respective channels that may be selected.

7. A fast tuning subsystem according to any one of Claims 1 to 6 characterized in that each of said predicted voltage signals is predetermined for the respective channels for the particular said tuner (124) to be substantially equal at the time of predetermination to the voltage applied to said voltage controlled oscillator (130) that provides a null tuning error signal.

8. A fast tuning subsystem according to any one of Claims 1 to 7 characterized in that said error detecting means (150) includes means for comparing the frequency of said voltage controlled oscillator (130) with said reference (140) to generate said tuning error signal.

9. A fast tuning subsystem according to Claim 8 characterized in that said error detecting means (150) comprises a reference oscillator (148) for generating a reference signal at a frequency that is l/N times the frequency of said voltage controlled oscillator (130) at the freqeuncy at which said tuner (124) selectively receives respective channels, where N is a different respective integer for each channel, means responsive to said voltage controlled oscillator (130) for dividing the output frequency thereof by N, and comparison means (150) for comparing the divided by N signal with said reference signal to produce said tuning error signal.

10. A fast tuning subsystem according to Claim 9 characterized in that said means for decoupling includes a loop filter (152) in circuit with said feedback means (144).

11. A method for establishing in memory (138) a table of predicted control voltages for a slew control for a fast tuning subsystem for use in switching from a current channel to a selected channel of a television system, the tuning subsystem comprising a tuner (124) for selecting a channel to be received, said tuner (124) including a voltage controlled oscillator (130) having a control input for determining, in response to a control voltage applied to said control input, the channel frequency said tuner (124) selectively receives, and a slew control for supplying a selected predicted control voltage signal to said control input of said oscillator (130), said slew control including an associated memory means (138) for storing signals corresponding to respective control voltage signals predicted for applying to said oscillator (130) to tune said tuner (124) to receive the channel frequencies of the respective channels, and further including means interconnected between said memory means (138) and said control input of said oscillator (130) for applying one of said respective predicted control voltage signals as said selected predicted control voltage signal to said control input of said oscillator (130), said oscillator being responsive to said selected predicted control voltage signal to slew the channel frequency at a rapid slew rate to the frequency corresponding to said selected predicted control voltage signal; said tuning subsystem further comprising error detecting means (150),including a reference (148), for generating a tuning error signal indicative of the tuning error of the tuner (124) of the frequency for the selected channel, and feedback means (144) for combining said tuning error signal with said selected predicted control voltage signal to provide a control signal at said control input for adjusting said channel frequency to reduce said tuning error; said method characterized by a calibration mode automatically performed to establish a table of the predicted control voltage signals (138), said calibration mode comprising, for each of a plurality of channels, applying to said control input a respective preliminary control voltage signal corresponding to a previously predicted control voltage signal for that channel, utilizing the resulting tuning error signal from said error detecting means (150) to determine the control voltage signal at said control input as reduces the tuning error signal to less than a predetermined magnitude, and storing in said memory means (138) a signal corresponding to said determined control voltage as a signal corresponding to a respective predicted control voltage signal.

12. A method according to Claim 11 characterized in that the error detecting means (150) and the feedback means (144) comprise a phase-locked loop generating a tuning error signal indicative of phase error, the derivative of the tuning error signal is utilized to modify the preliminary control voltage signal to produce a modified preliminary control voltage signal, and a signal corresponding to the then modified preliminary control voltage signal is stored in memory (138) as corresponding to said determined control voltage signal.

13. A method according to either one of Claims 11 and 12 characterized in that said determination of said determined control voltage signal is made for each channel by applying a respective preliminary control voltage signal to said control input, utilizing the resulting tuning error signal to modify the preliminary control voltage signal by a predetermined amount to produce a modified preliminary control voltage signal, applying the modified preliminary control voltage signal to said control input, and repeating the steps until the resulting tuning error signal is less than said predetermined magnitude.

14. A method according to Claim 13 characterized in that each said predetermined amount is in accordance with a binary search process wherein successive predetermined amounts decrease by half.

15. A method according to Claim 13 characterized in that each said predetermined amount is substantially the same in accordance with a linear search process.

16. A method according to Claim 13 characterized in that each said predetermined amount is in accordance with a binary search process for a number of steps wherein successive predetermined amounts decrease by half and is thereafter in accordance with a linear search process wherein each said predetermined amount is substantially the same.

## Patentansprüche

1. Schnellabstimm-Untersystem zur Verwendung beim Schalten von einem laufenden Kanal auf einen ausgewählten Kanal eines Fernsehsystems mit einem Tuner (124) zur Auswahl eines zu empfangenden Kanals, der einen spannungsgesteuerten Oszillator (130) mit einem Steuereingang zur Festlegung der vom Tuner (124) selektiv empfangenen Kanalfrequenz in Abhängigkeit von einer an den Steuereingang angelegten Spannung enthält, Vorfestlegungsmitteln zum Anlegen eines ausgewählten vorfestgelegten Spannungssignals an den Steuereingang des Oszillators (130), die zugeordnete Speichermittel (138) enthalten, in denen Signale gespeichert sind, welche den jeweiligen Spannungssignalen entsprechen, die zum Anlegen an den Oszillator (130) zwecks Abstimmung des Tuners (124) auf dem Empfang der Kanalfrequenzen der jeweiligen Kanäle vorfestgelegt sind, zwischen die Speichermittel (138) und den Steuereingang des Oszillators (130) geschalteten Mitteln zum Anlegen eines der jeweiligen vorfestgelegten Spannungssignale als ausgewähltes vorfestgelegtes Spannungssignal an den Steuereingang des Oszillators (130), der auf das ausgewählte vorfestgelegte Spannungssignal im Sinne einer schnellen Einstellung der Kanalfrequenz auf die dem ausgewählten vorfestgelegten Spannungssignal entsprechende Frequenz anspricht, eine Referenz (148) enthaltenden Fehlerdetektormitteln (150) zur Erzeugung eines ein Maß für die Verstimmung des Tuners gegen die Frequenz des ausgewählten Kanals darstellenden Abstimmfehlersignals sowie mit Rückkoppelmitteln (144) zur Kombination des Abstimmfehlersignals mit dem ausgewählten vorfestgelegten Spannungssignal zwecks Erzeugung eines Steuersignals am Steuereingang für die Einstellung der Kanalfrequenz im Sinne der Reduzierung der Verstimmung, **gekennzeichnet durch** Mittel zu einer ins Gewicht fallenden Entkopplung der Funktion der Vorfestlegungsmittel von der Funktion der Rückkoppelmittel durch Erzeugung einer Rückkoppelmittel-Ansprechzeit, die lang in Bezug auf die Ansprechzeit der Vorfestlegungsmittel (144) ist, um eine ins Gewicht fallende Störung des Rückkoppelbetriebs der Rückkoppelmittel (144) durch Übergänge im Einstellbetrieb der Vorfestlegungsmittel zu verhindern.

2. Schnellabstimm-Untersystem nach Anspruch 1, **dadurch gekennzeichnet**, daß die Mittel zur ins Gewicht fallenden Entkopplung eine so ausreichend schnelle Einstellung der Kanalfrequenz durch die Vorfestlegungsmittel bewirken, daß die gesamte während des Einstellbetriebs detektierte Ton-ZF-Schallrauschenergie so klein ist, daß sie für einen Betrachter unhörbar ist, wodurch durch den Betrieb der Vorfestlegungsmittel veranlaßte Übergänge den Betrieb der Rückkoppelmittel (144) nicht derart stören, daß eine übergangsweise sichtbare oder hörbare Beeinträchtigung des Bildes oder des Tons für den Betrachter sichtbar oder hörbar ist.

3. Schnellabstimm-Untersystem nach Anspruch 1 oder 2, **dadurch gekennzeichnet**, daß die Mittel zur ins Gewicht fallenden Entkopplung die Ansprechzeit der Rückkoppelmittel (144) im wesentlichen um vier Größenordnungen langsamer als die Ansprechzeit der Vorfestlegungsmittel machen.

4. Schnellabstimm-Untersystem nach den Ansprüchen 1 bis 3, **dadurch gekennzeichnet**, daß die Fehlerdetektormittel (150) Mittel zur Begrenzung der Größe des Fehlersignals bei der Einstellung zwischen Kanälen enthalten.

5. Schnellabstimm-Untersystem nach Anspruch 4, **dadurch gekennzeichnet**, daß die Fehlerdetektormittel (150) einen Phasenfehlerdetektor umfassen, der das Fehlersignal während der Einstellung zwischen Kanälen auf ±π Radianten begrenzt.

6. Schnellabstimm-Untersystem nach den Ansprüchen 1 bis 5, **dadurch gekennzeichnet**, daß die Speichermittel (138) einen adressierbaren Speicher umfassen, der an entsprechenden Adressen eine Vielzahl von digitalen Datensignalen speichert, welche den vorfestgelegten Spannungssignalen für jeweilige wählbare Kanäle entsprechen.

7. Schnellabstimm-Untersystem nach den Ansprüchen 1 bis 6, **dadurch gekennzeichnet**, daß die vorfestgelegten Spannungssignale für die entsprechenden Kanäle für den speziellen Tuner (124) jeweils so vorgegeben werden, daß sie im Zeitpunkt der Vorfestlegung im wesentlichen gleich der an den spannungsgesteuerten Oszillator (130) angelegten Spannung sind, welche ein Abstimmfehlersignal von Null hervorruft.

8. Schnellabstimm-Untersystem nach den Ansprüchen 1 bis 7, **dadurch gekennzeichnet**, daß die Fehlerdetektormittel (150) zur Erzeugung des Abstimmfehlersignals Mittel zum Vergleich der Frequenz des spannungsgesteuerten Oszillators (130) mit der Referenz (148) enthalten.

9. Schnellabstimm-Untersystem nach Anspruch 8, **dadurch gekennzeichnet**, daß die Fehlerdetektormittel (150) einen Referenzoszillator (148) zur Erzeugung eines Referenzsignals bei einer Frequenz, welche gleich der 1/N-fachen Frequenz des spannungsgesteuerten Oszillators (130) bei der Frequenz ist, bei welcher der Tuner (124) selektiv jeweilige Kanäle empfängt, wobei N für jeden Kanal eine andere jeweilige ganze Zahl ist, vom spannungsgesteuerten Oszillator (130) angesteuerte Mittel zur Teilung der Ausgangsfrequenz durch N sowie Vergleichsmittel (150) zum Vergleich des durch N geteilten Signals mit dem Referenzsignal zwecks Erzeugung des Abstimmfehlersignals umfassen.

10. Schnellabstimmuntersystem nach Anspruch 9, **dadurch gekennzeichnet**, daß die Mittel zur Entkopplung ein im Kreis der Rückkoppelmittel (144) liegendes Schleifenfilter (152) enthalten.

11. Verfahren zur Bildung einer Tabelle von vorfestgelegten Steuerspannungen in einem Speicher (138) für eine Einstellsteuerung eines Schnellabstimm-Untersystems zur Verwendung beim Schalten von einem laufenden Kanal auf einen ausgewählten Kanal eines Fernsehsystems, bei dem das Abstimmuntersystem einen Tuner (124) zur Auswahl eines zu empfangenden Kanals, einen im Tuner (124) enthaltenen spannungsgesteuerten Oszillator (130) mit einem Steuereingang zur Festlegung der durch den Tuner (124) selektiv empfangenen Kanalfrequenz in Abhängigkeit von der an den Steuereingang angelegten Steuerspannung, eine Einstellsteuerung zum Anlegen eines ausgewählten vorfestgelegten Steuerspannungssignals an den Steuereingang des Oszillators (130), die einen zugeordneten Speicher (138) zur Speicherung von Signalen enthält, die den jeweiligen Steuerspannungssignalen entsprechen, welche für das Anlegen an den Oszillator (130) zwecks Abstimmung des Tuners (124) auf den Empfang der Kanalfrequenzen der jeweiligen Kanäle vorfestgelegt sind, zwischen die Speichermittel (138) und den Steuereingang des Oszillators (130) geschaltete Mittel zum Anlegen einer der jeweiligen vorfestgelegten Steuerspannungssignale als ausgewähltes vorfestgelegtes Steuerspannungssignal an den Steuereingang des Oszillators (130), der auf das ausgewählte vorfestgelegte Steuerspannungssignal im Sinne der schnellen Einstellung der Kanalfrequenz auf die dem ausgewählten vorfestgelegten Steuerspannungssignal entsprechende Frequenz anspricht, eine Referenz (148) enthaltende Fehlerdetektormittel (150) zur Erzeugung eines ein Maß für die Verstimmung des Tuners (124) gegen die Frequenz des ausgewählten Kanals darstellenden Abstimmfehlersignals sowie Rückkoppelmittel (144) zur Kombination des Abstimmfehlersignals mit dem ausgewählten vorfestgelegten Steuerspannungssignal zwecks Erzeugung eines Steuersignals am Steuereingang für die Einstellung der Kanalfrequenz im Sinne einer Reduzierung des Abstimmfehlers umfaßt, **gekennzeichnet durch** eine automatisch durchgeführte Eichbetriebsart zur Bildung einer Tabelle der vorfestgelegten Steuerspannungssignale (138), bei der für jeden einer Vielzahl von Kanälen ein einem vorher vorfestgelegten Steuerspannungssignal für den jeweiligen Kanal entsprechendes vorläufiges Steuerspannungssignal an den Steuereingang angelegt wird, das resultierende Abstimmfehlersignal von den Fehlerdetektormitteln (150) zur Festlegung des Steuerspannungssignal am Eingang als das Abstimmfehlersignal auf weniger als eine vorgegebene Größe reduzierend verwendet wird und in den Speichermitteln (138) ein der festgelegten Steuerspannung entsprechendes Signal als einem jeweiligen vorfestgelegten Steuerspannungssignal entsprechendes Signal gespeichert wird.

12. Verfahren nach Anspruch 11, **dadurch gekennzeichnet,** daß die Fehlerdetektormittel (150) und die Rückkoppelmittel (144) eine phasenstarre Schleife umfassen, welche ein ein Maß für einen Phasenfehler darstellendes Abstimmfehlersignal erzeugt, die Ableitung des Abstimmfehlersignals zur Modifizierung des vorläufigen Steuerspannungssignals zwecks Erzeugung eines modifizierten vorläufigen Steuerspannungssignals verwendet wird und ein dem dann modifizierten vorläufigen Steuerspannungssignal entsprechendes Signal im Speicher (138) als festgelegtes Steuerspannungssignal gespeichert wird.

13. Verfahren nach den Ansprüchen 11 und 12, **dadurch gekennzeichnet,** daß die Festlegung des festgelegten Steuerspannungssignals für jeden Kanal durch Anlegen eines jeweiligen vorläufigen Steuerspannungssignals an den Steuereingang, Verwendung des resultierenden Abstimmfehlersignals zur Modifizierung des vorläufigen Steuerspannungssignals um einen vorgegebenen Betrag zwecks Erzeugung eines modifizierten vorläufigen Steuerspannungssignals, Anlegen des modifizierten vorläufigen Steuerspannungssignals an den Steuereingang und Wiederholung der Schritte erfolgt, bis das resultierende Abstimmfehlersignal kleiner als die vorgegebene Größe ist.

14. Verfahren nach Anspruch 13, **dadurch gekennzeichnet,** daß der jeweilige vorgegebene Betrag mit einem binären Suchprozeß in Übereinstimmung steht, in dem aufeinanderfolgende vorgegebene Beträge um die Hälfte abnehmen.

15. Verfahren nach Anspruch 13, **dadurch gekennzeichnet,** daß der jeweilige vorgegebene Betrag in Übereinstimmung mit einem linearen Suchprozeß im wesentlichen der gleiche ist.

16. Verfahren nach Anspruch 13, **dadurch gekennzeichnet,** daß der jeweilige vorgegebene Betrag in Übereinstimmung mit einem binären Suchprozeß für eine Anzahl von Schritten steht, worin aufeinanderfolgende vorgegebene Beträge um die Hälfte abnehmen, und danach in Übereinstimmung mit einem linearen Suchprozeß steht, in dem der jeweilige vorgegebene Betrag im wesentlichen der gleiche ist.

## Revendications

1. Sous-système d'accord rapide pour utilisation en commutation d'un canal courant vers un canal sélectionné d'un système de télévision, ledit sous-système d'accord comprenant un sélecteur de canaux (124) pour sélectionner un canal à recevoir, ledit sélecteur de canaux (124) comprenant un oscillateur commandé en tension (130) ayant une entrée de commande pour déterminer, en réponse à la tension appliquée à ladite entrée de commande, la fréquence de canal que ledit sélecteur de canaux (124) reçoit de façon sélective, et des moyens de prédiction pour délivrer un signal de tension prédit sélectionné à ladite entrée de commande dudit oscillateur (130), ledit moyen de prédiction incluant un moyen de mémoire associé (138) dans lequel sont mémorisés des signaux correspondant aux signaux de tension respectifs prédits pour application audit oscillateur (130) pour accorder ledit sélecteur de canaux (124) pour recevoir les fréquences de canal des canaux respectifs, et comprenant en outre un moyen interconnecté entre ledit moyen de mémoire (138) et ladite entrée de commande dudit oscillateur (130)' pour appliquer l'un desdits signaux de tension prédits respectifs, comme signal de tension prédit sélectionné, à ladite entrée de commande dudit oscillateur (130), ledit oscillateur (130) étant sensible audit signal de tension prédit sélectionné pour balayer la fréquence de canal à une vitesse de balayage rapide jusqu'à la fréquence correspondant audit signal de tension prédit sélectionné ; ledit sous-système d'accord comprenant en outre un moyen détecteur d'erreur (150), comprenant une référence (148), pour produire un signal d'erreur d'accord indicatif de l'erreur d'accord du sélecteur de canaux par rapport à la fréquence du canal sélectionné ; un moyen de contre-réaction (144) pour combiner ledit signal d'erreur d'accord avec ledit signal de tension prédit sélectionné pour fournir un signal de commande à ladite entrée de commande pour ajuster ladite fréquence de canal pour réduire ladite erreur d'accord ; ledit sous-système d'accord étant caractérisé par un moyen pour découpler pratiquement le fonctionnement dudit moyen de prédiction du fonctionnement dudit moyen de contre-réaction pour fournir un temps de réponse du moyen de contre-réaction qui soit relativement long par rapport au temps de réponse du moyen de prédiction (144) pour empêcher les transitoires dans le mode de balayage dudit moyen de prédiction de perturber sensiblement le mode de contreréaction dudit moyen de contre-réaction (144).

2. Sous-système d'accord rapide selon la revendication 1, caractérisé en ce que ledit moyen pour découpler pratiquement fait en sorte que la vitesse à laquelle la fréquence de canal est balayée par ledit moyen de prédiction soit suffisamment rapide pour que l'énergie totale des parasites entre stations, détectée pendant le mode de balayage, soit suffisamment faible pour être inaudible par un téléspectateur, ce par quoi les transitoires provoquées par le fonctionnement dudit moyen de prédiction ne perturbent pas suffisamment le fonctionnement dudit moyen de contre-réaction (144) pour provoquer une dégradation visible, ou audible, de l'image, ou du son, observée, ou écouté par un téléspectateur.

3. Sous-système d'accord rapide selon l'une ou l'autre des revendications 1 ou 2, caractérisé en ce que ledit moyen pour découpler pratiquement rend le temps de réponse dudit moyen de contre-réaction (144) plus petit d'au moins quatre facteurs dix que le temps de réponse dudit moyen de prédiction.

4. Sous-système d'accord rapide selon l'une quelconque des revendications 1 à 3, caractérisé en ce que ledit moyen détecteur d'erreur (150) comprend un moyen pour limiter le signal d'erreur en amplitude pendant ledit balayage entre canaux;

5. Sous-système d'accord rapide selon la revendication 4, caractérisé en ce que ledit moyen détecteur d'erreur (150) comprend un détecteur d'erreur de phase limitant ledit signal d'erreur à ± π radians pendant ledit balayage entre canaux.

6. Sous-système d'accord rapide selon l'une quelconque des revendications 1 à 5, caractérisé en ce que ledit moyen de mémoire (138) comprend une mémoire adressable mémorisant au droit d'adresses respectives une pluralité de signaux de données numériques correspondant aux signaux de tension prédits pour les canaux respectifs qui peuvent être sélectionnés.

7. Sous-système d'accord rapide selon l'une quelconque des revendications 1 à 6, caractérisé en ce que chacun desdits signaux de tension prédits est prédéterminé pour les canaux respectifs, pour ledit sélecteur de canaux (124) particulier, pour être sensiblement égal, à l'instant de prédétermination, à la tension appliquée audit oscillateur commandé en tension (130) qui fournit un signal d'erreur d'accord nul.

8. Sous-système d'accord rapide selon l'une quelconque des revendications 1 à 7, caractérisé en ce que ledit moyen détecteur d'erreur (150) comprend un moyen pour comparer la fréquence dudit oscillateur commandé en tension (130) avec ladite référence (140) pour produire ledit signal d'erreur d'accord.

9. Sous-système d'accord rapide selon la revendication 8, caractérisé en ce que ledit moyen détecteur d'erreur (150) comprend : un oscillateur de référence (148) pour produire un signal de référence à une fréquence qui est 1/N fois la fréquence dudit oscillateur commandé en tension (130) à la fréquence à laquelle ledit sélecteur de canaux (124) reçoit de manière sélective les canaux respectifs, où M est un nombre entier respectif différent pour chaque canal ; un moyen sensible audit oscillateur commandé en tension (130) pour diviser sa fréquence de sortie par N ; et un moyen de comparaison (150) pour comparer le signal divisé par M audit signal de référence pour produire ledit signal d'erreur d'accord.

10. Sous-système d'accord rapide selon la revendication 9, caractérisé en ce que ledit moyen de découplage comprend un filtre en boucle (152) en circuit avec ledit moyen de contre-réaction (144).

11. Procédé pour établir dans une mémoire (138) une table de tensions de commande prédites pour une commande de balayage pour un sous-système d'accord rapide pour utilisation en commutation d'un canal courant vers un canal sélectionné d'un système de télévision, ledit sous-système d'accord comprenant un sélecteur de canaux (124) pour sélectionner un canal à recevoir, ledit sélecteur de canaux (124) comprenant un oscillateur commandé en tension (130) ayant une entrée de commande pour déterminer, en réponse à la tension appliquée à ladite entrée de commande, la fréquence de canal que ledit sélecteur de canaux (124) reçoit de façon sélective, et une commande de balayage pour délivrer un signal de tension de commande prédit sélectionné à ladite entrée de commande dudit oscillateur (130), ladite commande de balayage comprenant un moyen de mémoire (138) associé pour mémoriser des signaux correspondants aux signaux de tension de commande respectifs prédits pour application audit oscillateur (130) pour accorder ledit sélecteur de canaux (124) pour recevoir les fréquences de canal des canaux respectifs, et comprenant en outre un moyen interconnecté entre ledit moyen de mémoire (138) et ladite entrée de commande dudit oscillateur (130) pour appliquer l'un desdits signaux de tension prédits respectifs, comme signal de tension prédit sélectionné, à ladite entrée de commande dudit oscillateur (130), ledit oscillateur étant sensible audit signal de tension prédit sélectionné pour balayer la fréquence de canal à une vitesse de balayage rapide jusqu'à la fréquence correspondant audit signal de tension prédit sélectionné ; ledit sous-système d'accord comprenant en outre un moyen détecteur d'erreur (150), comprenant une référence (148), pour produire un signal d'erreur d'accord indicatif de l'erreur d'accord du sélecteur de canaux (124) par rapport à la fréquence du canal sélectionné ; et un moyen de contre-réaction (144) pour combiner ledit signal d'erreur d'accord avec ledit signal de tension prédit sélectionné pour fournir un signal de commande à ladite entrée de commande pour ajuster ladite fréquence de canal pour réduire ladite erreur d'accord ; ledit procédé étant caractérisé par un mode d'étalonnage effectué automatiquement pour établir une table des signaux de tension de commande prédits (138), ledit mode d'étalonnage comprenant, pour chacun d'une pluralité de canaux : l'application à ladite entrée de commande d'un signal de tension de commande préliminaire respectif correspondant à un signal de tension de commande prédit préalablement pour ce canal ; l'utilisation du signal d'erreur d'accord résultant issu dudit moyen détecteur d'erreur (150) pour déterminer le signal de tension de commande au droit de ladite entrée de commande qui réduit le signal d'erreur d'accord à une valeur plus petite qu'une valeur prédéterminée ; et la mémorisation dans ledit moyen de mémoire (138) d'un signal correspondant à ladite tension de commande déterminée comme signal correspondant à un signal de tension de commande prédit respectif.

12. Procédé selon la revendication 11, caractérisé en ce que le moyen détecteur d'erreur (150) et le moyen de contre-réaction (144) comprennent une boucle à phase asservie produisant un signal d'erreur d'accord indicatif de l'erreur de phase, en ce que la dérivée du signal d'erreur d'accord est utilisée pour modifier le signal de tension de commande préliminaire pour produire un signal de tension de commande préliminaire modifié, et en ce qu'un signal correspondant au signal de tension de commande préliminaire ainsi modifié est mémorisé dans la mémoire (138) comme correspondant audit signal de tension de commande déterminé.

13. Procédé selon l'une ou l'autre des revendications 11 et 12, caractérisé en ce que ladite détermination dudit signal de tension de commande déterminé est faite pour chaque canal par application d'un signal de tension de commande préliminaire respectif à ladite entrée de commande, en utilisant le signal d'erreur d'accord résultant pour modifier le signal de tension de commande préliminaire d'une quantité prédéterminée pour produire un signal de tension de commande préliminaire modifié, en appliquant le signal de tension de commande préliminaire modifié à ladite entrée de commande, et en répétant les étapes jusqu'à ce que le signal d'erreur d'accord résultant soit plus petit que ladite valeur prédéterminée.

14. Procédé selon la revendication 13, caractérisé en ce que chacune desdites quantités prédéterminées est fonction d'un traitement de recherche par dichotomie dans lequel des quantités prédéterminées successives décroissent de moitié.

15. Procédé selon la revendication 13, caractérisé en ce que chacune desdites quantités est sensiblement la même en fonction d'un traitement de recherche linéaire.

16. Procédé selon la revendication 13, caractérisé en ce que chacune desdites quantités prédéterminées est fonction d'un traitement de recherche par dichotomie pour un certain nombre d'étapes dans lesquelles des quantités prédéterminées successives décroissent de moitié et est ensuite fonction d'un traitement de recherche linéaire dans lequel chacune desdites quantités prédéterminées est sensiblement la même.
